# EUROPÄISCHE PATENTSCHRIFT

(11) **EP 1 958 231 B1**
(45) Veröffentlichungstag und Bekanntmachung des Hinweises auf die Patenterteilung: **23.05.2018**
(21) Anmeldenummer: 05816963.2
(22) Anmeldetag: 06.12.2005
(51) Int. Cl.: H01J 37/153, H01J 37/26

(54) **KORREKTIV ZUR BESEITIGUNG DES ÖFFNUNGSFEHLERS 3. ORDNUNG UND DES AXIALEN FARBFEHLERS 1. ORDNUNG 1. GRADES**
CORRECTIVE FOR ELIMINATING THE THIRD-ORDER APERTURE ABERRATION AND THE FIRST-ORDER, FIRST-DEGREE AXIAL CHROMATIC ABERRATION
CORRECTION D'ÉLIMINATION DE L'ERREUR D'OUVERTURE DE TROISIEME ORDRE ET DE L'ERREUR CHROMATIQUE AXIALE DE PREMIER ORDRE ET DU PREMIER DEGRE

(43) Veröffentlichungstag der Anmeldung: 20.08.2008
(73) Patentinhaber: Ceos Corrected Electron Optical Systems GmbH, 69125 Heidelberg (DE)
(72) Erfinder: MÜLLER, Heiko, 69115 Heidelberg (DE); ROSE, Harald, 64287 Darmstadt (DE); UHLEMANN, Stephan, 69115 Heidelberg (DE)
(74) Vertreter: Weber & Seidel
(86) Internationale Anmeldenummer: PCT/DE2005/002210
(87) Internationale Veröffentlichungsnummer: WO 2007/065382

(56) Entgegenhaltungen:
- EP-A- 1 381 073
- US-A1- 2003 034 457
- US-A1- 2004 155 200
- US-A1- 2005 023 480

## Beschreibung

Die Erfindung bezieht sich auf ein Korrektiv zur Beseitigung des Öffnungsfehlers 3. Ordnung und des axialen Farbfehlers 1. Ordnung 1. Grades, bestehend aus zwei in Richtung der optischen Achse hintereinander angeordneten Korrekturstücken, wobei jedes Korrekturstück aus Multipolelementen zur Erzeugung mehrerer Quadrupolfelder und mindestens einem Oktupolfeld besteht und jedes Korrekturstück zu seiner Mittelebene symmetrisch aufgebaut ist, wobei jedes Korrekturstück aus einer ungeraden Anzahl von Multipolelementen zur Erzeugung von mindestens 5 Quadrupolfeldern und mindestens einem Qktupolfeld besteht, das Multipolelement zur Erzeugung des mittleren Quadrupolfeldes zur Mittelebene des Korrekturstücks zentriert angeordnet und das Quadrupolfeld kombiniert elektrisch und magnetisch ist, die Quadrupolfelder im zweiten Korrekturstück zu denen im ersten Korrekturstück antisymmetrisch orientiert sind, und das mittlere Quadrupolfeld jedes Korrekturstücks von einem Oktupolfeld überlagert ist.

Elektronenoptische Abbildungssysteme werden sowohl zur Vergrößerung, wie im Fall der Elektronenmikroskopie, als auch zur Verkleinerung in der Elektronenprojektionslithographie eingesetzt. Der Vorteil gegenüber lichtoptischen Abbildungssystemen ist ihr wesentlich höheres Auflösungsvermögen, das sich aus der wesentlich geringeren Wellenlänge der abbildenden optischen Strahlen ergibt. Gegenüber Licht erbringen elektronenoptische Abbildungssysteme in Abhängigkeit von der Beschleunigungsspannung eine Verbesserung der Auflösung um einen Faktor von ca. 10⁴.

Die Führung von Elektronenstrahlen zum Zwecke der Abbildung erfolgt mit Hilfe elektrischer und/oder magnetischer Linsen. Derartige Linsensysteme sind in Abhängigkeit von ihrem Aufbau und ihrer Anordnung mit den unterschiedlichsten Bildfehlern behaftet, die sich wie folgt klassifizieren:
Axiale Bildfehler: Hierbei handelt es sich um jene Bildfehler, die bei Abbildung eines Achsenpunktes auftreten und nur vom Öffnungswinkel des vom Achsenpunkt ausgehenden Strahls abhängig sind.

Außeraxiale Bildfehler: Sie treten bei der Abbildung eines außeraxialen Bildpunktes auf und werden durch den Abstand des Bildpunktes von der optischen Achse (sowie ggf. auch noch zusätzlich vom Öffnungswinkel) bestimmt. Jene Bildfehler, die ausschließlich durch ihren Abstand von der optischen Achse bestimmt werden, nennt man Verzeichnung.

Chromatische Bildfehler: Da die abbildenden Teilchen nicht monochromatisch sind, d. h. unterschiedliche Geschwindigkeiten aufweisen, treten chromatische Fehler auf, die ihrerseits in axiale und außeraxiale Farbfehler unterteilt werden können und dementsprechend vom Öffnungswinkel und/oder vom Abstand zur optischen Achse mitbestimmt werden.

Die axialen und außeraxialen Bildfehler werden zusammenfassend als geometrische Bildfehler bezeichnet, um sie gegenüber den chromatischen Bildfehlern abzugrenzen. Schließlich werden die axialen Bildfehler, nachdem sie nur vom Öffnungswinkel abhängen, auch als Öffnungsfehler bezeichnet.

Die Leistungsfähigkeit hochauflösender elektronenoptischer Systeme, wie sie z. B. in der Elektronenmikroskopie Verwendung finden, wird durch die sphärische Aberration (= Öffnungsfehler 3. Ordnung) und den axialen Farbfehler 1. Ordnung 1. Grades der Objektivlinse begrenzt. Es wurden deshalb erhebliche Anstrengungen unternommen mithilfe entsprechender Korrektive diese Fehler zu eliminieren. Einer der erfolgversprechendsten Wege ist die Verwendung von Korrektiven, die aus Multipolen, insbesondere solchen, die Quadrupolfelder und Oktupolfelder erzeugen, aufgebaut sind.

Aus der DE-A 101 59 308 A1 ist ein Korrektiv bekannt, welches eine doppeltsymmetrische Anordnung von Quadrupolfeldern und Oktupolfeldern zeigt. Als Nachteil dieser Anordnung ist anzusehen, dass keine Oktupolfelder zur Korrektur der außeraxialen Koma dritter Ordnung vorgesehen sind und dass die Oktupole zur Korrektur des Öffnungsfehlers auf Grund ihrer Anordnung große koma-artige Bildfehler 5. Ordnung induzieren. Das gezeigte Prinzip der Öffnungs- und Farbfehlerkorrektur in astigmatischen Zwischenbildern hat sich als unvereinbar mit der für die höchstauflösende Transmissionselektronenmikroskopie zwingenden Forderung nach einer hohen Bildpunktzahl erwiesen.

Aus der US2005/0023480 A1 ist ein Korrektiv der eingangs genannten Art bekannt. Für die Öffnungsfehlerkorrektur werden Oktupolfelder in Bereiche von astigmatischen Zwischenbildern gelegt, welche durch die Strahlformung mittels der Quadrupolfelder erzeugt werden. Auch dieser Korrektor arbeitet nach dem Prinzip der Öffnungs- und Farbfehlerkorrektur in astigmatischen Zwischenbildern, was mit der für die höchstauflösende Transmissionselektronenmikroskopie zwingenden Forderung nach einer hohen Bildpunktzahl unvereinbar ist.

Aus der US2003/0034457 A1 ist ein Korrektiv mit zwei Korrekturelementen bekannt, zwischen denen ein als Rundlinsendublett ausgebildetes Transferlinsensystem für einen antisymmetrischen Strahlengang in den Korrekturelementen sorgt. Ansonsten ist dieses Korrektiv allerdings anders aufgebaut als das eingangs erwähnte Korrektiv, da es mit einer Kombination von Rundlinsen und Hexapolen arbeitet.

Ausgehend von einem Korrektiv der eingangs genannten Art hat sich die Erfindung zur Aufgabe gemacht, ein Korrektiv verfügbar zu machen, das eine Korrektur des Öffnungsfehlers 3. Ordnung sowie des axialen Farbfehlers 1. Ordnung 1. Grades bei einer so hohen Bildpunktzahl erlaubt, wie sie für die höchstauflösende Transmissionselektronenmikroskopie erforderlich ist.

Gelöst wird diese Aufgabe erfindungsgemäß dadurch, daß die Einstellung der Quadrupolfelder derart erfolgt, dass ein Zwischenbild im wesentlichen im 1. und letzten Quadrupolfeld eines jeden Korrekturstücks liegt, und zwischen den Korrekturstücken ein Transferlinsensystem zur Mittelebene des Korrektivs symmetrisch angeordnet ist, welches mindestens eine Rundlinse aufweist und die Einstellung des Transferlinsensystems so erfolgt, dass die Mittelebenen der beiden Korrekturstücke anamorph aufeinander abgebildet werden, wobei die Vergrößerung in dem einen Hauptschnitt das Reziproke der Vergrößerung im anderen Hauptschnitt ist.

Das Verhältnis der elektrischen und magnetischen Quadrupolfeldstärke kann unabhängig von der resultierenden Brechkraft des kombinierten Elements variiert und so eingestellt werden, dass der Farbfehler des Gesamtsystems bestehend aus Korrektiv und Objektivlinse verschwindet. Dem elektrisch-magnetischen Quadrupolfeld des Korrekturstücks ist ein Oktupolfeld zur Korrektur des Öffnungsfehlers überlagert.

Die Quadrupolfelder im zweiten Korrekturstück sind antisymmetrisch zu denen im ersten Korrekturstück orientiert. Die Oktupolfelder zur Öffnungsfehlerkorrektur sind dagegen symmetrisch bzgl. der Mittelebene des Korrektivs orientiert.

Das Transferlinsensystem zwischen den beiden Korrekturstücken besteht aus mindestens einer Rundlinse.

Das Transferlinsensystem ist so eingestellt, dass die Mittelebenen der beiden Korrekturstücke optisch konjugierte Ebenen sind. Die resultierende Abbildung zwischen diesen beiden Ebenen ist stigmatisch und anamorph, d.h. die Vergrößerung bezüglich der beiden Hauptabschnitte ist unterschiedlich, wobei darüber hinaus die Vergrößerung in dem einen Schnitt (1. Hauptschnitt) das Reziproke der Vergrößerung des anderen Schnitts (2. Hauptschnitt) ist. Die Vergrößerung im 1. und 2. Hauptschnitt zwischen den beiden Mittelebenen der Korrekturstücke unterscheidet sich voneinander, sodass im Bereich der kombiniert elektrisch-magnetischen Quadrupolfelder das von einem Bildpunkt ausgehende axiale Strahlenbündel daher einen stark elliptischen Querschnitt hat. Im ersten Korrekturstück ist die längere Halbachse der Querschnittsellipse in x-Richtung orientiert und die Korrektur erfolgt vorzugsweise im xz-Schnitt. Im zweiten Korrekturstück ist die längere Halbachse der Querschnittsellipse in y-Richtung orientiert und die Korrektur erfolgt vorzugsweise in y-Richtung. Beide Korrekturstücke zusammen bewirken die vollständige Korrektur des axialen Farbfehlers 1. Ordnung 1. Grades und des Öffnungsfehlers 3. Ordnung der Objektivlinse in beiden Hauptschnitten.

Das Prinzip der Korrektur in zueinander konjugierten anamorphen Ebenen ersetzt erfindungsgemäß das Prinzip der Korrektur in astigmatischen Zwischenbildern.

Das Korrektiv führt wegen seiner Symmetrie keinen zwei-zähligen Sternfehler 3. Ordnung S₃ ein. Es verbleibt daher den durch das Korrektiv eingeführten vier-zählige Astigmatismus 3. Ordnung A₃ zu korrigieren. Dies erfolgt durch ein einzelnes Oktupolfeld, dass in einer zu den Mittelebenen der Korrektorstücke optisch konjugierten Ebene positioniert ist.

Der Aufbau in Richtung der optischen Achse ist wie folgt:
Zunächst finden sich zwei Quadrupolfelder hintereinander beabstandet. Dem sich daran anschließenden dritten Quadrupolfeld sind ein oder mehrere Oktupolfelder zugeordnet. Darin schließen sich symmetrisch zur Mittelebene des mittleren Quadrupolfelds zwei weitere Quadrupolfelder in symmetrischer Anordnung an. Zwischen den beiden Korrekturstücken ist in der Symmetrieebene das Transferlinsensystem eingebracht, das seinerseits ebenfalls zur Mittelebene symmetrisch ist. Es besteht in seinem allgemeinsten Aufbau aus mindestens einer Rundlinse. Das Transferlinsensystem ist derart eingestellt, dass die mittleren Quadrupolfelder und die Oktupolfelder der beiden Korrekturstücke aufeinander abgebildet werden. Das vorbeschriebene Korrektiv erlaubt es, den Öffnungsfehler dritter Ordnung C₃ sowie den Farbfehler erster Ordnung ersten Grades C_{c} (chromatische Aberration) zu eliminieren.

Bevorzugt ist ein aus 2 Rundlinsen identischer Brennweite f aufgebautes Transferlinsensystem. Der Abstand des letzten Quadrupols des ersten Korrekturstücks zur ersten Rundlinse des Transferlinsensystems beträgt f, ebenso wie der Abstand der zweiten Rundlinse vom ersten Quadrupol des zweiten Korrekturstücks. Der Abstand beider Rundlinsen beträgt 2f. Die Polaritäten der Linsen sind entgegengesetzt, derart dass sich ihre Beiträge zur Larmor-Drehung näherungsweise kompensieren.

In einer vorteilhaften Ausführungsform erfolgt die Einstellung des Korrektivs, genauer die Einstellung der Quadrupolfelder und des Transferlinsensystems in der Weise, dass die axialen Fundamentalbahnen als die vom Bildmittelpunkt ausgehenden (x_{α}, y_{ß})-Bahnen im 1. und letzten Quadrupol jeden Korrekturstücks die optische Achse schneiden, dort also ein Zwischenbild zu liegen kommt, und die außeraxialen Bahnen (x_{γ}, y_{δ}), die jeweils im xz- bzw. yz-Schnitt liegen, in der Mitte des mittleren Quadrupolfeldes jedes Korrekturstücks die optische Achse schneiden und somit dort ein stigmatisches Beugungsbild der Eingangsbildebene erzeugen. Die Fundamentalbahnen haben demnach folgenden Verlauf:
Im xz-Schnitt verläuft die Fundamentalbahn x_{α} durch die Mitte des ersten Quadrupols und wird deshalb nicht abgelenkt. Dort findet sich demnach ein Zwischenbild. Im zweiten und dritten Quadrupolfeld erfolgt die Ablenkung in entgegengesetzte Richtungen, wobei der weitere Verlauf der Fundamentalbahn aufgrund der Symmetrie des Korrekturstücks ebenfalls symmetrisch ist. Das Transferlinsensystem bewirkt, dass die Fundamentalbahn in das zweite Korrekturstück in gleicher Weise eintritt, wie in das erste Korrekturstück. Aufgrund der Antisymmetrie der Quadrupolfelder entspricht der weitere Verlauf im zweiten Korrekturstück dem Verlauf der y_{β}-Bahn im ersten Korrekturstück.

Im xz-Schnitt verläuft die außeraxiale Fundamentalbahn x_{γ} in der Weise, dass die Fundamentalbahn achsparallel in den ersten Quadrupol eintritt und hierdurch - im Gegensatz zur Fundamentalbahn x_{α}, die durch den Mittelpunkt des Quadrupols geht und deshalb unabgelenkt bleibt - eine Ablenkung in Richtung auf die optische Achse zu erfährt. Die Fundamentalbahn x_{γ} durchläuft den zweiten Quadrupol im achsennahen Bereich, so dass nur eine geringe Ablenkung erfolgt und schneidet dann in der Mitte des dritten Quadrupols die optische Achse. Der weitere Verlauf der Fundamentalbahn x_{γ} ist zur Mittelebene des Korrekturstückes antisymmetrisch.
In dem sich anschließenden Transferlinsensystem verläuft die Fundamentalbahn x_{γ} ebenfalls antisymmetrisch, schneidet also die optische Achse in der Mitte des Transferlinsensystems. Aus diesem Grunde tritt die Fundamentalbahn x_{γ} ebenso wie in das erste Korrekturstück auch in das zweite Korrekturstück ein. Aufgrund der Antisymmetrie der Quadrupolfelder entspricht der weitere Verlauf der x_{γ}-Bahn im zweiten Korrekturstück dem Verlauf der Fundamentalbahn y_{δ} im ersten Korrekturstück.

Im yz-Schnitt gilt folgendes: Die vom Bildmittelpunkt ausgehende Fundamentalbahn y_{β} durchstößt die optische Achse im ersten Quadrupol und bleibt somit unbeeinflusst. Im zweiten Quadrupol erfolgt also eine Ablenkung in Richtung auf die optische Achse zu. Im dritten Quadrupol erfolgt eine Ablenkung von y_{β} weg von der optischen Achse, um anschließend in der zweiten Hälfte aufgrund der Symmetrie der Felder auch einen symmetrischen Verlauf zur Mittelebene des ersten Korrekturstückes vorzunehmen. Im Transferlinsensystem wird die Fundamentalbahn y_{β} zur optischen Achse hin umgelenkt in der Weise, dass y_{β} in das zweite Korrekturstück in gleicher Richtung eintritt wie in das erste Korrekturstück. Aufgrund der Antisymmetrie der Quadrupolfelder entspricht der weitere Verlauf der y_{β}-Bahn im zweiten Korrekturstück dem Verlauf der Fundamentalbahn x_{α} im ersten Korrekturstück.

Die außeraxiale Fundamentalbahn y_{δ} tritt in den ersten Quadrupol parallel im Abstand zur optischen Achse ein, erfährt eine Ablenkung von der optischen Achse weg und wird im zweiten Quadrupol zur optischen Achse hin gelenkt. In der Mitte des dritten Quadrupolfeldes wird die optische Achse durchstoßen, und aufgrund der symmetrischen Felder tritt die Fundamentalbahn um 180° gedreht aus dem ersten Korrekturstück aus und hat somit im ersten Korrekturstück einen antisymmetrischen Verlauf zur Mitte des dritten Quadrupols. Im weiteren Verlauf durchläuft y_{δ} das Transferlinsensystem antisymmetrisch. Der Eintritt in das zweite Korrekturstück erfolgt so wie in das erste Korrekturstück. Aufgrund der Antisymmetrie der Quadrupolfelder entspricht der weitere Verlauf der y_{δ}-Bahn im zweiten Korrekturstück dem Verlauf der Fundamentalbahn x_{γ} im ersten Korrekturstück.

Die vorbeschriebene Anordnung eines Korrektivs ist im allgemeinsten Fall mit einem vierzähligen Astigmatismus dritter Ordnung A₃ behaftet. Zu dessen Beseitigung werden zwei alternative Lösungen aufgezeigt. In der ersten ist vorgesehen in der Mitte des Transferlinsensystems ein Oktupolfeld anzubringen, das so einzustellen ist, dass der vierzählige Astigmatismus kompensiert wird. Als Alternative kann ein Oktupolfeld zur Korrektur des selben Bildfehlers auch außerhalb des Korrektivs angeordnet werden. Im letzteren Fall ist eine zusätzliche einfache Transferlinse TL3 erforderlich, welche dafür sorgt, dass die Mitte des externen Oktupolfeldes konjugiert zu den Mittelebenen der Korrekturstücke ist. Das externe Oktupolfeld und die zusätzliche Transferlinse können in Strahlrichtung gesehen vor oder hinter dem Korrektiv angeordnet sein. Befindet sich das Oktupolfeld in der Mitte des Transferlinsensystems, ist diese Bedingung auch ohne die Verwendung der zusätzlichen Transferlinse TL3 erfüllt.

Für die bauliche Ausgestaltung und Verwirklichung von Quadrupol- und Oktupolfelder können die an sich bekannten Multipole verwendet werden, die in Abhängigkeit von ihrer Zähligkeit die Erzeugung sowohl eines Quadrupol- als auch eines Oktupolfeldes erlauben. Die bauliche Einheit Multipol gestattet somit die Erzeugung sich überlagernder mehrzähliger Felder. Bevorzugt ist die Verwendung eines Dodecapolelementes, welches die gleichzeitige Erzeugung sich überlagernder Quadrupol- und Oktupolfelder auf elektrischem und/oder magnetischem Wege erlaubt.

Zur Reduzierung der axialen Fehler 5. Ordnung kann die oben beschriebene Erfindung über das bisher beschriebene Systems hinaus weitergebildet werden durch Überlagerung von Dodecapolfeldern im Bereich der Korrekturstücke in zur Mitte der Korrekturstücke symmetrischer Anordnung. Auch kann dem zentralen bzw. externen Oktupolfeld ein Dodecapolfeld überlagert werden. Besonders bevorzugt ist die Erzeugung von Dodecapolfeldern auf dem mittleren Multipolelement eines jeden Korrekturstücks in zur Mittelebene des Korrektivs antisymmetrischer Orientierung und auf den Multipolelementen unmittelbar vor und nach den mittleren Quadrupolfeldern der Korrekturstücke. Diese Dodecapolfelder sind symmetrisch zur Mitte des Korrekturelements und antisymmetrisch zur Mitte des Korrektivs orientiert. Diese zuletzt beschriebene besonders bevorzugte Weiterbildung erlaubt die Einstellung der sphärischen Aberration 5. Ordnung über einen weiten Bereich um 0 der die optimalen Abbildungsbedingungen für die Amplitudenkontrastabbildung und die Phasenkontrastabbildung im Transmissionselektronenmikroskop einschließt. Neben der für den axialen Bildpunkt erzielbaren Punktauflösung ist die Größe des mit gleichbleibender optischer Qualität übertragbaren Bildfeldes für die hochauflösende Elektronenmikroskopie von entscheidender Bedeutung. Die Größe des nutzbaren Bildfeldes, quantifiziert durch die Anzahl der mit gleichbleibender optischer Qualität übertragenen Bildpunkte, wird durch die außeraxialen Fehler, die linear mit dem Abstand des Bildpunktes von der optischen Achse abhängen, bestimmt. Bildfehler die von höheren Potenzen des Achsenabstandes abhängen, spielen für die Höchstauflösung wegen ihrer Kleinheit keine Rolle.
Der linear vom Achsenabstand abhängige Bildfehler 3. Ordnung einer herkömmlichen Objektivlinse wird als außeraxiale Koma bezeichnet. Dieser Bildfehler bleibt bei Korrektiven herkömmlicher Bauart unkorrigiert. Dieser Mangel hat zur Folge, das mit herkömmlichen Objektivlinsen und Korrektiven zur Korrektur des Farb- und Öffnungsfehlers bei einer avisierten Punktauflösung von 0.05nm bei einer Beschleunigungsspannung von 200kV nur ein Bildfeld von weniger als 400x400 Bildpunkten übertragen werden kann, was für den Einsatz in der höchstauflösenden Elektronenmikroskopie unzureichend ist. Hier wird die Übertragung von mindestens 2000x2000 Bildpunkten gefordert, um die Kapazitäten der eingesetzten planaren Elektronendetektoren (CCD Kamera) ausnutzen zu können.

Um die Anzahl der mit vergleichbarer optischer Qualität übertragbaren Bildpunkte zu steigern, hat es sich als notwendig erwiesen, zusätzliche Oktupolfelder zur Korrektur der außeraxialen Koma 3. Ordnung der Objektivlinse vorzusehen und durch eine geeignete Anordnung der Oktupolfelder zur Korrektur des Öffnungsfehlers, die induzierten koma-artigen Fehler 5. Ordnung gezielt zu minimieren, da diese anderenfalls eine nicht akzeptable Beschränkung der Bildpunktzahl bedingen.

Zu diesem Zweck werden zu Beginn und Ende des mittleren Quadrupolfeldes jedes Korrekturstückes jeweils unmittelbar anschließend ein Oktupolfeld angeordnet. Im Transferlinsensystem werden ebenfalls zwei Oktupolfelder mit gleichem Abstand vor und hinter der Mittelebene des Korrektivs angebracht. Für den Fall, dass im Transferlinsensystem die Korrektur des vierzähligen Astigmatismus vorgenommen wird, befinden sich dann drei Oktupolfelder im Transferlinsensystem. Außerdem werden in jedem Korrekturstück jeweils unmittelbar vor und hinter dem mittleren Quadrupolfeld zwei Oktupolfelder angeordnet. Diese zusätzlichen Oktupolfelder werden zusammen mit den beiden weiter oben beschriebenen Oktupolfeldern im Bereich des Transfersystems so eingestellt, dass die außeraxiale Koma 3. Ordnung korrigiert ist.
Zusammen mit der Objektivlinse bildet das Korrektiv dann ein aplanatisches und achromatisches Abbildungssystem, d.h. Öffnungsfehler, axialer Farbfehler und außeraxiale Koma sind simultan korrigiert. Im Hinblick auf die Korrektur der beschriebenen Bildfehler eignet sich das Korrektiv ohne Einschränkung der Allgemeinheit in besonderer Weise zum Einsatz in hochauflösenden Transmissionselektronenmikroskopen (TEM). Neben der für die Hochauflösung bedeutenden Beseitigung des Öffnungsfehlers dritter Ordnung als auch der des chromatischen Bildfehlers garantiert die Beseitigung der außeraxialen Koma die Übertragung eines großen Bildfeldes.

Zwischen Korrektiv und Objektivlinse ist ein Transferlinsensystem notwendig, das aus mindestens einer Rundlinse aufgebaut ist. Zusammen mit der Objektivlinse bildet dieses Transfersystem die Objektebene vergrößert in die Eingangsbildebene des Korrektivs ab. Die Einstellung des Transfersystems ist so gewählt, dass die Mittelebenen der Korrekturstücke optisch konjugiert zur korrektivseitigen Brennebene der Objektivlinse sind, d.h. bei paralleler Beleuchtung des Objekts kommen demnach Beugungsbilder der Objektebene in der Mitte der Korrekturstücke zu liegen.

Aufgrund dieser speziellen Anordnung werden alle außeraxialen Bildfehler 5. Ordnung, die linear im Abstand von der optischen Achse sind, klein, da die Oktupolfelder im mittleren Quadrupol und sowohl das optionale Oktupolfeld in der Mitte des Transferlinsensystems als auch das alternative Oktupolfeld am Ende des Korrektivs, welche der Korrektur der axialen Bildfehler dritter Ordnung dienen, jeweils in Beugungsbildern liegen und nicht zu einer Beschränkung des Bildfeldes beitragen.

Weitere Einzelheiten, Merkmale und Vorteile der Erfindung lassen sich dem nachfolgenden Teil der Beschreibung entnehmen. In diesem werden Aufbau und paraxialer Strahlengang des erfindungsgemäßen Korrektivs anhand einer in schematischer Darstellung gehaltenen Zeichnung näher erläutert. Es zeigen:
- **Figur 1**: die Anordnung der fokussierenden Elemente des Korrektivs im xz- und yz- Schnitt.
- **Figur 2**: die Anordnung der Oktupolfelder in dem System gemäß Figur 1.
- **Figur 3**: die Anordnung eines externen Oktupolfelds in dem System gemäß Figur 1.

Im folgenden werden die Quadrupolfelder als QP, die Oktupolfelder mit OP und die Transferlinsen mit TL bezeichnet Das Korrektiv ist im Hinblick auf die Quadrupolfelder antisymmetrisch zur Mittelebene M und innerhalb des ersten (zweiten) Korrekturstücks symmetrisch zur Mittelbene S (S').

Die Objektebene des abbildenden Systems wird durch die Objektivlinse und ggf. durch ein Transferlinsensystem in das erste Quadrupolfeld QP 1 des ersten Korrekturstückes abgebildet. Dementsprechend verlaufen die axialen Fundamentalbahnen x_{α} y_{β} näherungsweise durch die Mitte des Quadrupolfeldes QP1 und erfahren keine Ablenkung. Die außeraxialen Fundamentalbahnen x_{γ},y_{δ} werden, nachdem die beiden Fundamentalbahnen in verschiedenen Hauptschnitten verlaufen, in unterschiedlichen Richtungen abgelenkt. Das sich in Richtung des Strahlenganges entlang der optischen Achse anschließende nächste Quadrupolfeld QP 2 lenkt die außeraxialen Fundamentalbahnen x_{γ} und y_{δ} derart ab, dass sie im dritten Quadrupolfeld QP 3 mittig die optische Achse durchlaufen. Die axialen Fundamentalbahnen x_{α} und y_{β} werden von QP3 zur optischen Achse hin bzw. von dem optischen Weg gebrochen. Dieses dritte Quadrupolfeld QP 3 ist kombiniert elektrisch- magnetisch aufgebaut, sodass unter Beibehaltung seiner Gesamtstärke und durch Einstellung des Anteiles der elektrischen und der magnetischen Quadrupolfeldstärke eine Beeinflussung und Elimination des axialen Farbfehlers 1. Ordnung und 1. Grades möglich wird. Nachdem jedes Korrekturstück zu seiner Mittelebene S symmetrisch aufgebaut ist, schließen sich in Symmetrie die Quadrupolfelder QP 2' und QP1' an.

Im Anschluss an das erste Korrekturstück befindet sich das Transferlinsensystem TL2, welches aus zwei im Abstand 2f zueinander angeordneten identischen Rundlinsen TL21 und TL22 der Brennweite f besteht. Sie bilden ein 4f-System bei dem die Eingangsbildebene die Mittelebene des letzten Quadrupolfeldes QP1' des ersten Korrekturstücks und die Ausgangsbildebene die Mittelebene des ersten Quadrupolfeldes QP1" des zweiten Korrekturstücks darstellt. Aufgrund der geforderten Antisymmetrie der Quadrupolfelder, ist das zweite Korrekturstück im Hinblick auf die Orientierung der Quadrupolfelder antisymmetrisch aufgebaut. Die räumliche Anordnung unter Vernachlässigung der Polarität ist bei den einzelnen Multipolelementen gleich. Im xz-Schnitt erhält man also einen Strahlengang im zweiten Korrekturstück, der dem im yz-Schnitt im ersten Korrekturstück entspricht (und umgekehrt).

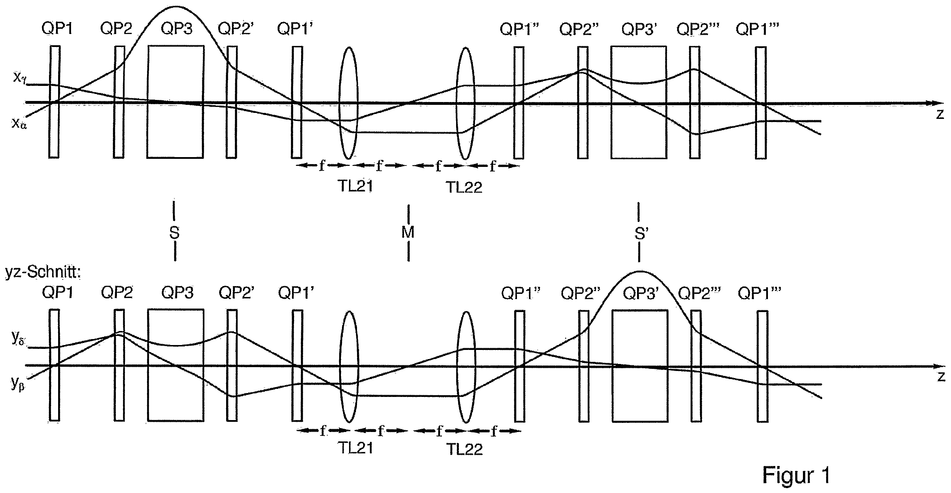

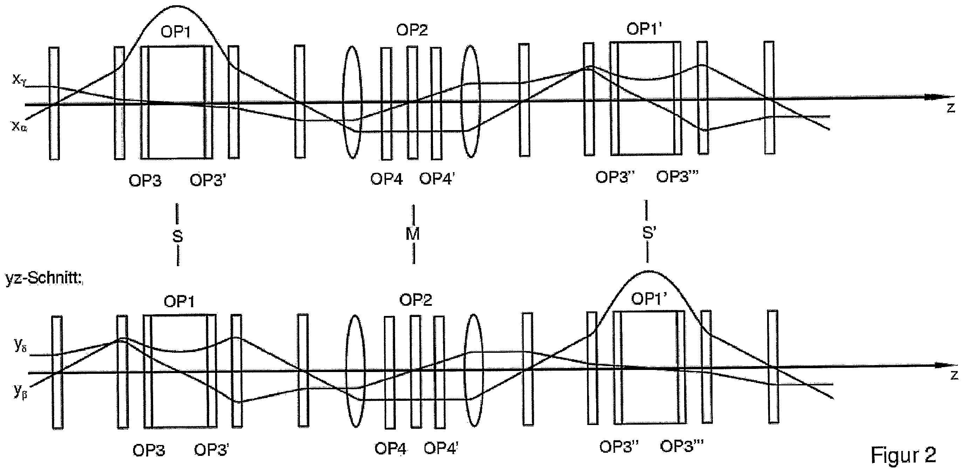

Figur 2 zeigt die Anordnung der Oktupolfelder bei dem in Figur 1 beschriebenen Korrektiv. Der Aufbau stimmt folglich mit dem in Figur 1 beschriebenen überein, so dass zur Vermeidung von Wiederholungen hierauf Bezug genommen wird.

Den Quadrupolfeldern QP3, QP3' ist jeweils ein Oktupolfeld OP1, OP1' überlagert und in der Mittelebene des Korrektivs M befindet sich ein weiteres Oktupolfeld OP2. Die beschriebenen Oktupolfelder sind symmetrisch bezüglich der Ebene M orientiert und dienen der vollständigen Korrektur der axialen Fehler 3. Ordnung.

Unmittelbar vor und hinter den mittleren Quadrupolfeldern QP3 bzw. QP3' sind Oktupolfelder OP3, OP3' bzw. OP3", OP3'" angeordnet. Ebenso befindet sich ein Paar von Oktupolfeldern OP4, OP4' im Bereich zwischen den Transferlinsen TL21/TL22. Diese Oktupolfelder, die sich nicht im Bereich von Nullstellen der außeraxialen Fundamentalbahnen befinden dienen der vollständigen Korrektur des außeraxialen Koma 3. Ordnung.

Das in der Mittelebene des Korrektivs angeordnete Oktupolfeld OP2 dient der Korrektur des vierzähligen Astigmatismus 3. Ordnung.

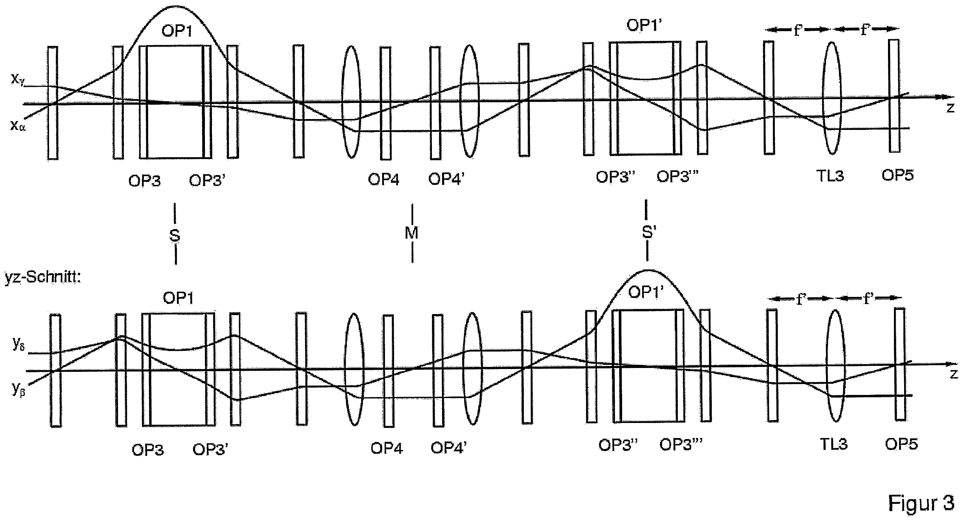

Figur 3 zeigt die Anordnung der Oktupolfelder für den Fall, dass die Korrektur des vier-zähligen Astigmatismus 3. Ordnung durch ein außerhalb des Korrektivs angeordnetes Oktupolfeld OP5 erfolgt. Der Aufbau stimmt im übrigen mit dem in Figur 1 beschriebenen überein, so dass zur Vermeidung von Wiederholungen hierauf Bezug genommen wird. Den Quadrupolen QP3, QP3' ist jeweils ein Oktupolfeld OP1, OP1' überlagert. Eine einzelne zusätzliche Transferlinse TL3 mit Brennweite f schließt sich an das zweite Korrekturstück im Abstand f von der Mitte dessen letzten Quadrupols QP1"' an und erzeugt ein Bild der Mittelebenen der Korrekturstücke S, S' im Abstand 2f von der Mitte von QP1"', dort befindet sich das Oktupolfeld OP5. Die beschriebenen Oktupolfelder OP1, OP1" sind symmetrisch bezüglich der Ebene M orientiert und dienen zusammen mit OP5 der vollständigen Korrektur der axialen Fehler 3. Ordnung.

## Patentansprüche

1. Korrektiv zur Beseitigung des Öffnungsfehlers 3. Ordnung und des axialen Farbfehlers 1. Ordnung 1. Grades, bestehend aus zwei in Richtung der optischen Achse hintereinander angeordneten Korrekturstücken, wobei jedes Korrekturstück aus Multipolelementen zur Erzeugung mehrerer Quadrupolfelder (QP) und mindestens einem Oktupolfeld (OP) besteht und jedes Korrekturstück zu seiner Mittelebene (S, S') symmetrisch aufgebaut ist, wobei jedes Korrekturstück aus einer ungeraden Anzahl von Multipolelementen zur Erzeugung von mindestens 5 Quadrupolfeldern (QP) und mindestens einem Qktupolfeld (OP) besteht,
das Multipolelement zur Erzeugung des mittleren Quadrupolfeldes (QP3, QP3') zur Mittelebene des Korrekturstücks (S, S') zentriert angeordnet und das Quadrupolfeld (QP3, QP3') kombiniert elektrisch und magnetisch ist,
die Quadrupolfelder (QP) im zweiten Korrekturstück zu denen im ersten Korrekturstück antisymmetrisch orientiert sind, und
das mittlere Quadrupolfeld (QP3, QP3') jedes Korrekturstücks von einem Oktupolfeld (OP1, OP1') überlagert ist,
**dadurch gekennzeichnet,**
**daß** die Einstellung der Quadrupolfelder (QP) derart erfolgt, dass ein Zwischenbild im wesentlichen im 1. und letzten Quadrupolfeld (QP1, QP1') eines jeden Korrekturstücks liegt, und
zwischen den Korrekturstücken ein Transferlinsensystem (TL) zur Mittelebene (M) des Korrektivs symmetrisch angeordnet ist,
welches mindestens eine Rundlinse aufweist und die Einstellung des Transferlinsensystems (TL) so erfolgt, dass die Mittelebenen (S, S') der beiden Korrekturstücke anamorph aufeinander abgebildet werden, wobei die Vergrößerung in dem einen Hauptschnitt das Reziproke der Vergrößerung im anderen Hauptschnitt ist.

2. Korrektiv nach Anspruch 1, **dadurch gekennzeichnet, dass** das Transferlinsensystem aus 2 Rundlinsen (TL21, TL22) der Brennweite f aufgebaut ist, die jeweils im Abstand f zu den benachbarten Quadrupolfeldern (QP1', QP1") des ersten und zweiten Korrekturstücks und im Abstand 2 f zueinander angeordnet sind.

3. Korrektiv nach einem der vorgehergehenden Ansprüche, **dadurch gekennzeichnet, dass** das Transferlinsensystem (TL) ein Multipolelement aufweist, das um die Mittelebene (M) des Korrektivs zentriert angeordnet ist und ein Oktupolfeld (OP2) erzeugt.

4. Korrektiv nach Anspruch 3, **dadurch gekennzeichnet, dass** das Multipolelement zusätzlich ein Dodekapolfeld erzeugt.

5. Korrektiv nach einem der vorhergehenden Ansprüche, **dadurch gekennzeichnet, dass** außerhalb des Korrektivs in einer zu den Mittelebenen (S, S') der Korrekturstücke optisch konjugierten Ebene ein Multipolelement angeordnet ist, das ein Oktupolfeld (OP5) erzeugt.

6. Korrektiv nach Anspruch 5, **dadurch gekennzeichnet, dass** das Multipolelement zusätzlich ein Dodecapolfeld erzeugt.

7. Korrektiv nach einem der vorhergehenden Ansprüche, **dadurch gekennzeichnet, dass** das mittlere Quadrupolfeld (QP3, QP3') jedes Korrekturstücks als auch das jeweils überlagerte Oktupolfeld (OP1, OP1') in einem Multipolelement erzeugt werden.

8. Korrektiv nach Anspruch 7, **dadurch gekennzeichnet, dass** die Multipolelemente Dodecapolelemente sind und zu den vorgenannten Feldern zusätzlich überlagerte Dodecapolfelder in antisymmetrischer Orientierung zur Mitte des Korrektivs erzeugen.

9. Korrektiv nach einem der vorhergehenden Ansprüche,
**dadurch gekennzeichnet, dass**
das Transferlinsensystem (TL) zwei Multipolelemente aufweist, die äquidistant vor und hinter der Mittelebene (M) des Korrektivs angeordnet sind und Oktupolfelder (OP4, OP4') erzeugen.

10. Korrektiv nach einem der vorhergehenden Ansprüche, **dadurch gekennzeichnet, dass** in jedem Korrekturstück jeweils unmittelbar vor und hinter dem Multipolelement zur Erzeugung des mittleren Quadrupolfeldes (QP3, QP3') ein Multipolelement angeordnet ist, das Oktupolfelder (OP3, OP3', OP3", OP3'") erzeugt.

11. Korrektiv nach Anspruch 10, **dadurch gekennzeichnet, dass** das Multipolelement auch überlagerte Dodecapolfelder erzeugt, wobei diese Dodekapolfelder symmetrisch zur Mitte der Korrekturelemente und antisymmetrisch zur Mitte des Korrektivs orientiert sind.

12. Elektronenmikroskop unter Verwendung eines Korrektivs gemäß einem der vorangehenden Ansprüche, **dadurch gekennzeichnet, dass** dem Korrektiv die Objektivlinse vor- oder nachgeschaltet ist und dazwischen ein Transferlinsensystem angeordnet ist, welches die Objektebene vergrößert in den Bereich der Eingangsbildebene des Korrektivs abbildet und die Mittelebenen der Korrekturstücke (S, S') und die korrektivseitige Brennebene der Objektivlinse zu konjugierten Ebenen macht.

13. Elektronenmikroskop unter Verwendung eines Korrektivs gemäß einem der Ansprüche 1-11 **dadurch gekennzeichnet, dass** vor oder hinter dem Korrektiv eine weitere Transferlinse (TL3) und ein Multipolelement zur Erzeugung eines Oktupolfeldes (OP5) angeordnet sind, wobei erstere die Mittelebenen der Korrekturstücke (S, S') in die Mittelebene des Oktupolfeldes (OP5) abbildet.

14. Elektronenmikroskop unter Verwendung eines Korrektivs gemäß einem der Ansprüche 1-11 **dadurch gekennzeichnet, dass** einzelne der Oktupolfelder in Ebenen positioniert sind, die zur korrektivseitigen Brennebene der Objektivlinse konjugiert sind.

## Claims

1. A corrective for eliminating the third-order aperture aberration and the first-order, first-degree axial chromatic aberration, consisting of two correction pieces, which are arranged one behind the other in the direction of the optical axis, each correction piece consisting of multipole elements for generating a plurality of quadrupole fields (QP) and consisting of at least one octupole field (OP), and each correction piece being symmetrical with respect to the central plane (S, S') thereof, each correction piece consisting of an odd number of multipole elements for generating at least 5 quadrupole fields (QP) and consisting of at least one octupole field (OP),
the multipole element for generating the central quadrupole field (QP3, QP3') being centred with respect to the central plane of the correction piece (S, S'), and the quadrupole field (QP3, QP3') being electrical and magnetic,
the quadrupole fields (QP) in the second correction piece being oriented antisymmetrically to those in the first correction piece, and
an octupole field (OP1, OP1') being superimposed on the central quadrupole field (QP3, QP3') of each correction piece,
**characterised in that**
the setting of the quadrupole fields (QP) takes place in such a manner that an intermediate image lies substantially in the first and last quadrupole field (QP1, QP1') of each correction piece, and a transfer lens system (TL), which has at least one round lens, is arranged between the correction pieces, symmetrically to the central plane (M) of the corrective, and the setting of the transfer lens system (TL) takes place in such a manner that the central planes (S, S') of the two correction pieces are imaged anamorphically onto one another, wherein the enlargement in one main section is the reciprocal of the enlargement in the other main section.

2. The corrective according to Claim 1,
**characterised in that**
the transfer lens system is built up of two round lenses (TL21, TL22) of focal distance f, which are each arranged at the distance f from the adjacent quadrupole fields (QP1', QP1") of the first and second correction pieces and at the distance 2f from each other.

3. The corrective according to any one of the preceding claims,
**characterised in that**
the transfer lens system (TL) has a multipole element which is centred around the central plane (M) of the corrective and generates an octupole field (OP2).

4. The corrective according to Claim 3,
**characterised in that**
the multipole element also generates a dodecapole field.

5. The corrective according to any one of the preceding claims,
**characterised in that**
a multipole element which generates an octupole field (OP5) is arranged outside the corrective in a plane optically conjugate to the central planes (S, S') of the correction pieces.

6. The corrective according to Claim 5,
**characterised in that**
the multipole element also generates a dodecapole field.

7. The corrective according to any one of the preceding claims,
**characterised in that**
the central quadrupole field (QP3, QP3') of each correction piece and the respectively superimposed octupole field (OP1, OP1') are generated in a multipole element.

8. The corrective according to Claim 7,
**characterised in that**
the multipole elements are dodecapole elements and generate dodecapole fields superimposed additionally to the above-mentioned fields in an asymmetrical orientation to the centre of the corrective.

9. The corrective according to any one of the preceding claims,
**characterised in that**
the transfer lens system (TL) has two multipole elements which are arranged equidistantly in front of and behind the central plane (M) of the corrective and generate octupole fields (OP4, OP4').

10. The corrective according to any one of the preceding claims,
**characterised in that**
a multipole element which generates octupole fields (OP3, OP3', OP3", OP3"') is arranged in each correction piece directly in front of and behind the multipole element for generating the central quadrupole field (QP3, QP3').

11. The corrective according to Claim 10,
**characterised in that**
the multipole element also generates superimposed dodecapole fields, wherein these dodecapole fields are oriented symmetrically to the centre of the correction elements and antisymmetrically to the centre of the corrective.

12. An electron microscope using a corrective according to any one of the preceding claims,
**characterised in that**
the objective lens is arranged in front of or behind the corrective, and a transfer lens system is arranged therebetween which images the object plane in an enlarged manner in the region of the input image plane of the corrective and makes the central planes of the correction pieces (S, S') and the corrective-side focal plane of the objective lens conjugate planes.

13. An electron microscope using a corrective according to any one of Claims 1-11,
**characterised in that**
a further transfer lens (TL3) and a multipole element for generating an octupole field (OP5) are arranged in front of or behind the corrective, wherein the former images the central planes of the correction pieces (S, S') into the central plane of the octupole field (OP5) .

14. An electron microscope using a corrective according to any one of Claims 1-11,
**characterised in that**
some of the octupole fields are positioned in planes which are conjugate to the corrective-side focal plane of the objective lens.

## Revendications

1. Correction d'élimination de l'erreur d'ouverture de troisième ordre et de l'erreur chromatique axiale de premier ordre et du premier degré, composée de deux pièces de correction disposées l'une derrière l'autre dans une direction de l'axe optique, chaque pièce de correction étant composée d'éléments multipolaires pour produire plusieurs champs quadripolaires (QP) et au moins d'un champ octopolaire (OP) et chaque pièce de correction étant constituée de façon symétrique par rapport à son plan central (S,S'), chaque pièce de correction étant composée d'un nombre impair d'éléments multipolaires pour produire au moins 5 champs quadripolaires (QP) et au moins un champ octopolaire (OP), l'élément multipolaire pour produire le champ quadripolaire central (QP3,QP3') étant disposé centré par rapport au plan central de la pièce de correction (S,S') et le champ quadripolaire (QP3,QP3') étant combiné électriquement et magnétiquement,
les champs quadripolaires (QP) dans la deuxième pièce de correction étant orientés de façon antisymétrique par rapport à ceux dans la première pièce de correction, et
le champ quadripolaire central (QP3,QP3') de chaque pièce de correction étant superposé par un champ octopolaire (OP1,OP1'),
**caractérisée en ce que**
le réglage des champs quadripolaires (QP) a lieu de telle manière qu'une image intermédiaire se situe pour l'essentiel dans le premier et le dernier champ quadripolaire (QP1,QP1') de chacune des pièces de correction, et
un système de lentilles de transfert (TL) est disposé symétriquement entre les pièces de correction par rapport au plan central (M) de la correction,
lequel comporte au moins une lentille circulaire et le réglage du système de lentilles de transfert (TL) a lieu de telle sorte que les plans centraux (S,S') des deux pièces de correction forment des images anamorphiques superposées, l'agrandissement dans une des coupes principales étant la réciproque de l'agrandissement dans l'autre coupe principale.

2. Correction selon la revendication 1, **caractérisée en ce que** le système de lentilles de transfert est constitué de 2 lentilles circulaires (TL21, TL22) de focale f, qui sont disposées respectivement à distance f par rapport aux champs quadripolaires voisins (QP1', QP1") de la première et deuxième pièce de correction et à distance 2 f l'une par rapport à l'autre.

3. Correction selon l'une quelconque des revendications précédentes, **caractérisée en ce que** le système de lentilles de transfert (TL) comporte un élément multipolaire, qui est disposé centré autour du plan central (M) de la correction et produit un champ octopolaire (OP2).

4. Correction selon la revendication 3, **caractérisée en ce que** l'élément multipolaire produit en plus un champ dodécapolaire.

5. Correction selon l'une quelconque des revendications précédentes, **caractérisée en ce qu'**en dehors de la correction dans un plan optiquement conjugué par rapport aux plans centraux (S,S') des pièces de correction, est disposé un élément multipolaire qui produit un champ octopolaire (OP5).

6. Correction selon la revendication 5, **caractérisée en ce que** l'élément multipolaire produit en plus un champ dodécapolaire.

7. Correction selon l'une quelconque des revendications précédentes, **caractérisée en ce que** le champ quadripolaire central (QP3,QP3') de chaque pièce de correction ainsi que le champ octopolaire respectivement superposé (OP1,OP1') sont produits dans un élément multipolaire.

8. Correction selon la revendication 7, **caractérisée en ce que** les éléments multipolaires sont des éléments dodécapolaires et produisent par rapport aux champs précités des champs dodécapolaires superposés dans une orientation antisymétrique par rapport au centre de la correction.

9. Correction selon l'une quelconque des revendications précédentes, **caractérisée en ce que** le système de lentilles de transfert (TL) comporte deux éléments multipolaires, qui sont disposés à équidistance devant et derrière le plan central (M) de la correction et produisent des champs octopolaires (OP4, OP4').

10. Correction selon l'une quelconque des revendications précédentes, **caractérisée en ce que** dans chaque pièce de correction, un élément multipolaire est respectivement disposé directement devant et derrière l'élément multipolaire pour produire le champ quadripolaire central (QP3,QP3"), qui produit des champs octopolaires (OP3,OP3',OP3", OP3"').

11. Correction selon la revendication 10, **caractérisée en ce que** l'élément multipolaire produit également des champs dodécapolaires superposés, ces champs dodécapolaires étant orientés symétriquement par rapport au centre des éléments de correction et antisymétriquement par rapport au centre de la correction.

12. Microscope électronique utilisant une correction selon l'une quelconque des revendications précédentes, **caractérisé en ce que** la lentille d'objectif est disposée en amont ou en aval de la correction et un système de lentilles de transfert est disposé entre celles-ci, lequel reproduit le plan d'objectif agrandi dans la zone du plan d'image d'entrée de la correction et rend en plans conjugués les plans centraux des pièces de correction (S,S') et le plan focal côté correction de la lentille d'objectif.

13. Microscope électronique utilisant une correction selon l'une quelconque des revendications 1-11, **caractérisé en ce qu'**avant ou après la correction sont disposés une autre lentille de transfert (TL3) et un élément multipolaire pour produire un champ octopolaire (OP5), la première reproduisant les plans centraux des pièces de correction (S,S') dans le plan central du champ octopolaire (OP5).

14. Microscope électronique utilisant une correction selon l'une quelconque des revendications 1-11, **caractérisé en ce que** certains des champs octopolaires sont positionnés dans des plans qui sont conjugués en plan focal côté correction de la lentille d'objectif.
